# EUROPÄISCHE PATENTSCHRIFT

(11) **EP 1 182 505 B1**
(45) Veröffentlichungstag und Bekanntmachung des Hinweises auf die Patenterteilung: **27.09.2006**
(21) Anmeldenummer: 01120080.5
(22) Anmeldetag: 21.08.2001
(51) Int. Cl.: G03F 1/14, G03F 1/16, H01J 37/317, H01J 37/304

(54) **Vorrichtung und Verfahren zur Belichtung einer strahlungsempfindlichen Schicht mittels geladener Teilchen sowie Maske hierfür**
Device and process for exposing a radiation-sensitive coating using charged particles and mask therefor
Dispositif et procédé pour l'exposition d'une couche sensible aux radiations utilisant des particules chargées et masque à cet usage

(30) Priorität: 22.08.2000 DE 10041040
(43) Veröffentlichungstag der Anmeldung: 27.02.2002
(73) Patentinhaber: Carl Zeiss SMT AG, 73447 Oberkochen (DE)
(72) Erfinder: Kienzle, Oliver, Dr., 73430 Aalen (DE); Orchowski, Alexander, Dr., 73434 Aalen (DE)
(74) Vertreter: Diehl, Hermann O. Th.

(56) Entgegenhaltungen:
- US-A- 5 648 188
- PATENT ABSTRACTS OF JAPAN vol. 1999, no. 10, 31. August 1999 (1999-08-31) & JP 11 142121 A (NIKON CORP), 28. Mai 1999 (1999-05-28) & US 6 204 509 B1 (HIRAYANAGI NORIYUKI ET AL) 20. März 2001 (2001-03-20)
- FARROW R C ET AL: "MARKS FOR ALIGNMENT AND REGISTRATION IN PROJECTION ELECTRON LITHOGRAPHY" JOURNAL OF VACUUM SCIENCE AND TECHNOLOGY: PART B, AMERICAN INSTITUTE OF PHYSICS. NEW YORK, US, Bd. 11, Nr. 6, 1. November 1993 (1993-11-01), Seiten 2175-2178, XP000423361 ISSN: 0734-211X

## Beschreibung

Die Erfindung betrifft den Bereich der Herstellung von Bauelementen mittels lithografischer Verfahren und insbesondere die Belichtung strahlungsempfindlicher Schichten mittels geladener Teilchen, insbesondere eines Elektronenstrahls.

Bei den Bauelementen handelt es sich vornehmlich um stark miniaturisierte Bauelemente, wie etwa mikromechanische Strukturen oder integrierte Schaltungen (ICs). Im Fall der integrierten Schaltung enthält eine Maske (engl.: "reticle") ein Schaltungsmuster, das einer einzelnen Schicht der auf einem geeigneten Substrat, beispielsweise einem Silizium-Wafer, auszubildenden Schaltung entspricht. Zur Abbildung des Musters auf einem Zielbereich (engl.: "die") des Substrats wird letzteres zunächst mit einer strahlungsempfindlichen Schicht (engl.: "resist") bedeckt. Sodann wird die strahlungsempfindliche Schicht exponiert bzw. belichtet, indem das Muster der Maske mittels geladener Teilchen auf die strahlungsempfindliche Schicht abgebildet wird. Die strahlungsempfindliche Schicht wird darauf entwickelt, und es werden entweder die belichteten bzw. exponierten oder die unbelichteten bzw. nicht exponierten Bereiche der belichteten Schicht abgetragen. Die verbleibende Struktur der strahlungsempfindlichen Schicht dient dann als Maske in beispielsweise einem Ätzschritt, einem Ionenimplantationsschritt, einem Materialabscheidungsschritt oder ähnlichem.

Geladene Teilchen, beispielsweise Elektronen oder Ionen, werden hierbei eingesetzt, um derart kleine Strukturen herstellen zu können, deren Fertigung mittels herkömmlicher lichtoptischer Abbildung auf Grund der dort bestehenden Beugungsbeschränkung nicht oder nur unter Schwierigkeiten herstellbar sind.

Als Verfahren, das mit einem Elektronenstrahl zur Belichtung der strahlungsempfindlichen Schicht arbeitet, ist das SCALPEL-Verfahren ( Scattering with Angular Limitation in "Projection Electron-beam Lithography") bekannt. Dieses Verfahren ist beschrieben in dem Weisbuch "SCALPEL: A Projection Electron-Beam Approach to Sub-Optical Lithography", Technology Review, Dezember 1999, von J. A. Liddle, Lloyd R. Harriott, A.E. Novembre und W. K. Waskiewicz, Bell Laboratories, Lucent Technologies, 600 Mountain Avenue, Murray Hill, New Jersey 07974, USA. Weiterhin betreffen die Patentdokumente US 5 079 112, 5 130 213, 5 260 151, 5 376 505, US 5 258 246, US 5 316 879 sowie EP 0 953 876 A2 und EP 0 969 326 A2 das SCALPEL-Verfahren.

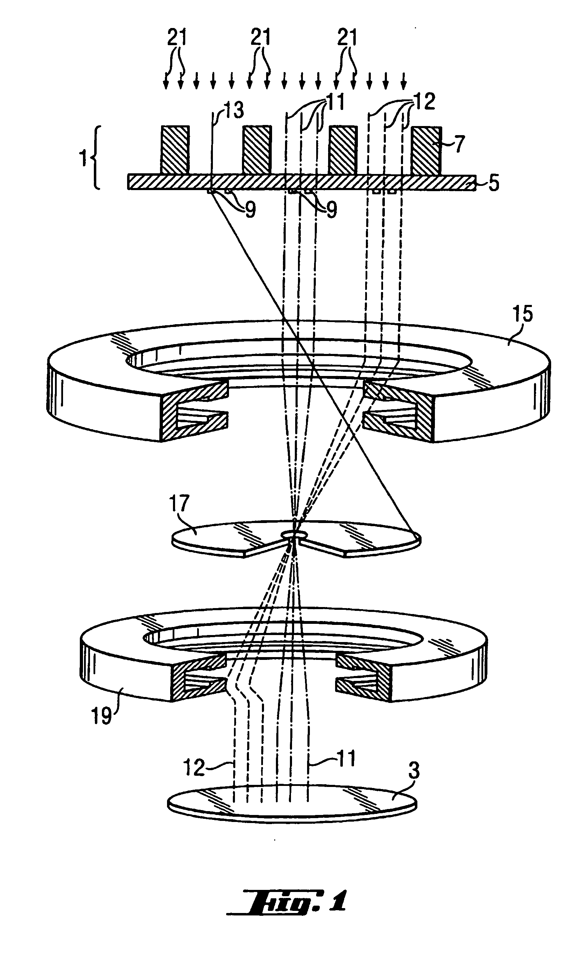

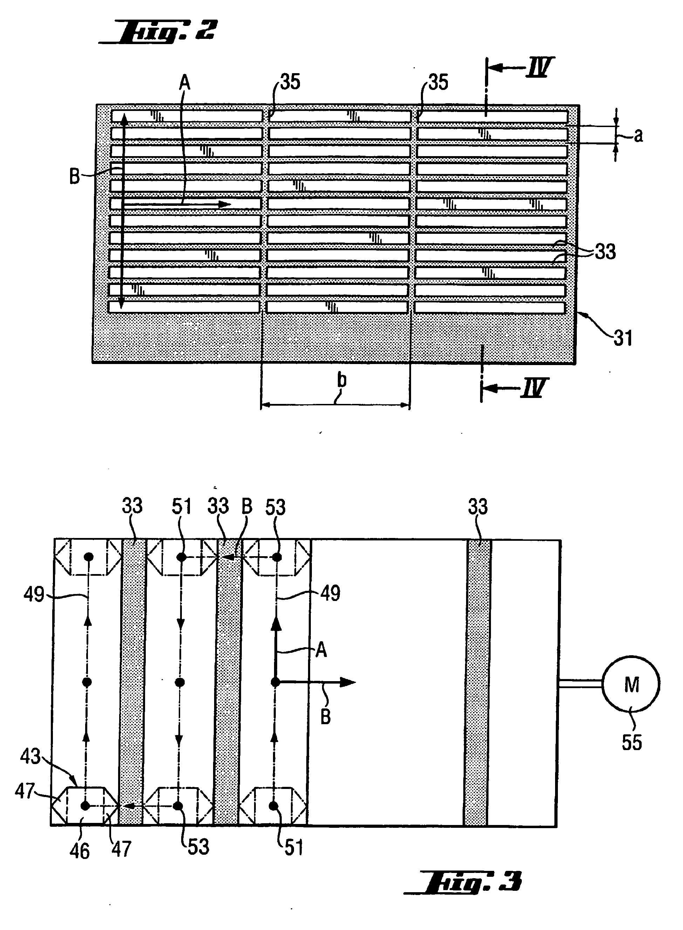

Das SCALPEL-Verfahren wird nachfolgend unter Bezugnahme auf Fig. 1 erläutert.

In Fig. 1 ist schematisch eine Maske 1 dargestellt, die zur Belichtung einer strahlungsempfindlichen Schicht auf einem Substrat 3 mittels eines Elektronenstrahls geeignet ist. Die Maske umfasst tragende Stege 7, an welchen eine Membranschicht 5 angebracht ist, die für die Elektronen relativ transparent ist. Das auf das Substrat 3 abzubildende Muster ist durch auf der relativ transparenten Membranschicht vorgesehene Streubereiche 9 gebildet. Lediglich die Membranschicht 5 und nicht die Streubereiche 9 durchsetzende Elektronenstrahlen 11 und 12 durchsetzen die Maske 1 im Wesentlichen ungestreut und im wesentlichen geradlinig, oder mit einem vergleichsweise kleinen Streuwinkel, während Elektronenstrahlen 13, welche die Membranschicht 5 und die Streubereiche 9 durchsetzen, in den Streubereichen 9 aus ihrer ursprünglichen Richtung mit einem größeren Streuwinkel abgelenkt werden. Die Elektronenstrahlen 11, 12, 13 verlaufen durch ein elektromagnetisches oder/und elektrostatisches Projektionslinsensystem 15 und werden durch dieses derart abgelenkt, dass die ungestreuten Elektronenstrahlen 11, 12 eine in einer Blende 17 vorgesehene Öffnung durchlaufen, während die mit größeren Streuwinkeln gestreuten Elektronen 13 von der Blende 17 absorbiert werden. Nach der Blende 17 durchlaufen die mit den kleineren Streuwinkeln gestreuten Elektronenstrahlen 11, 12 ein weiteres Projektionslinsensystem 19, welches die Strahlen 11, 12 zur Abbildung des Musters 9 auf das Substrat 3 fokussiert.

Das auf die Maske 1 fallende Elektronenfeld enthält auch Strahlen 21, die nicht wie die vorangehend beschriebenen Strahlen 11, 12, 13 in die Zwischenräume zwischen den Stegen 7 fallen, sondern die Stege 7 treffen. Aufgrund der Dicke der Stege 7 werden die Strahlen 21 mit einer höheren Wahrscheinlichkeit gestreut als die Strahlen 11 und 12, die lediglich die Membranschicht 5 durchsetzen. Deshalb werden die Bereiche der Maske, welche in ihrer Projektion entlang des Elektronenfelds unterhalb der Stege liegen, nicht für die Bildung des Musters verwendet. Entsprechend sollen Strahlen 21, die die Stege 7 und die Membranschicht ungestreut durchsetzen, auch nicht durch die Blende 17 auf das Substrat 3 gelangen.

Hierzu schlägt die EP 0 969 326 A2 einen räumlich begrenzten Elektronenstrahl vor, dessen Strahlquerschnitt in der Ebene der Maske so begrenzt ist, dass er die Maske an Zwischenräumen zwischen benachbarten Stegen durchsetzt und die Stege selbst nicht berührt. Dieser räumlich begrenzte Strahl wird dann relativ zur Maske in Erstreckungsrichtung der Stege verfahren, um die gesamten für die Bildung des Musters verwendeten Bereiche der Maske abzutasten. Im Hinblick auf die räumliche Definition des Strahlquerschnitts schlägt die EP 0 969 326 A2 beispielsweise die Verwendung von Blenden vor. Hierdurch ist es zwar möglich, den Strahl so zu formen, dass sein Strahlquerschnitt genau der lichten Weite zwischen benachbarten Stegen entspricht und somit eine Streuung der Elektronen an den Stegen vermeidbar ist, sofern der Strahl selbst bezüglich der Maske mit ausreichender Präzision positioniert ist und die Abtastbewegung des Strahls relativ zur Maske ebenfalls so präzise erfolgt, dass das Strahlenfeld die Stege nicht berührt. Zudem werden die Bereiche zwischen den Stegen der Maske auf aneinanderliegende Streifen auf dem zu belichtenden Substrat abgebildet. Positionsungenauigkeiten bei der Abtastung der Maske können dann zu Unterbelichtungen bzw. Doppelbelichtungen auf dem Substrat führen.

Aus JP 11 142121 A ist eine Projektionsvorrichtung bekannt, bei welcher Verzerrungen einer Maske gegenüber ihrer vorbestimmten Gestalt bestimmbar sind. Hierzu weist die Maske ein regelmäßiges Muster aus Markierungsbereichen auf. Die Markierungsbereiche werden unter anderem mit einem Elektronenstrahl abgetastet, um deren tatsächliche Position auf der Maske zu erfassen. Aus den Unterschieden zwischen den tatsächlichen Positionen und der vorbestimmten Positionen der Markierungsbereiche kann eine Verzerrung der Maske bestimmt werden. In Abhängigkeit von der Verzerrung der Maske erfolgt eine elektronenoptische Kompensation des Abbildungssystems während der Übertragung des Musters der Maske auf eine strahlungsempfindliche Schicht.

Ferner sind aus R.C. Farrow et al. "Marks for alignment and registration in projection electron lithography", 8257b Journals of Vacuum Science & Technology, B 11 (1993) Nov./Dec., No. 6, Thorofare, NJ, US, mögliche Arten von Markierungen im Bereich der strahlungsempfindlichen Schicht beschrieben, um eine Qualität der elektronenoptischen Abbildung zwischen Maske und strahlungsempfindlicher Schicht und eine relative Ausrichtung von Maske und strahlungsempfindlicher Schicht erfassen zu können.

Es ist eine Aufgabe der vorliegenden Erfindung, eine Vorrichtung und ein Verfahren bereitzustellen, um bei einer Projektionsvorrichtung einen Strahl projizierter geladener Teilchen entlang vorbestimmter Bahnen über eine Maske zu bewegen.

Ferner ist es eine Aufgabe der Erfindung eine hierfür geeignete Maske vorzuschlagen.

Die Aufgabe wird gelöst durch die Bereitstellung einer Projektionsvorrichtung gemäß Patentanspruch 1, eines Verfahrens gemäß Anspruch 24 und einer Maske gemäß Anspruch 10. Vorteilhafte Weiterbildungen der Erfindung sind in den abhängigen Ansprüchen angegeben.

Die Erfindung geht dabei aus von einer Maske, welche eine Membranschicht aus einem ersten Material, das Muster bildende Streubereiche aus einem geladene Teilchen stärker als die Membranschicht streuenden zweiten Material und eine Mehrzahl von mit Abstand voneinander angeordneten, sich geradlinig erstreckenden und die Membranschicht samt der Streubereiche tragenden Stützstegen umfasst.

Ferner geht die Erfindung aus von einer Projektionsvorrichtung zum Abbilden des Musters der Maske auf ein mit einer strahlungsempfindlichen Schicht versehenes Substrat mittels eines Strahls geladener Teilchen, wobei die Projektionsvorrichtung eine Strahlformungseinrichtung zum Erzeugen des Projektionsstrahls mit einem vorbestimmten Projektionsstrahlquerschnitt in der Maskenebene sowie eine Positionier-Bewegungseinrichtung umfasst, um den Projektionsstrahlquerschnitt der Maskenebene entlang einer vorbestimmten Bahn parallel zu einer Erstreckungsrichtung der Stege über die Maske zu bewegen.

Der Erfindung liegt der Gedanke zugrunde, an der Maske gezielt Markierungsbereiche vorzusehen, welche durch ein Material gebildet sind, welches sich hinsichtlich seiner Wechselwirkung mit den geladenen Teilchen von dem Material der Membranschicht und dem das Muster bildenden Material unterscheidet. Diese unterschiedliche, für das Markierungsmaterial charakteristische Wechselwirkung mit den geladenen Teilchen ist durch einen geeigneten Sensor nachweisbar, so dass der Sensor ein Messsignal abgibt, welches von der Anzahl der geladenen Teilchen abhängt, die den Markierungsbereich treffen. Werden nun die Markierungsbereiche an geeigneten Orten der Maske angebracht, kann das Messsignal dazu verwendet werden, die Position des Projektionsstrahlquerschnitts in der Maskenebene zu bestimmen und eine "Führung" für die Bewegung des Projektionsstrahlquerschnitts relativ zu der Maske zu bilden.

Die für das Markierungsmaterial charakteristische und diese von dem Material der Membranschicht und dem Material der Streubereiche unterscheidende Wechselwirkung kann in einer anderen bzw. verschiedenen Streuwirkung, Reflexionswirkung oder Absorptionswirkung für die geladenen Teilchen liegen, oder die unterscheidende Wechselwirkung kann auch in einer anderen oder verschiedenen Emissionswirkung für sekundäre Teilchen liegen, wie etwa Röntgenemission oder Augerelektronenemission. Wesentlich ist lediglich, dass diese unterscheidende Wechselwirkung durch ein geeignetes Messverfahren nachweisbar ist, so dass hierfür jeder geeignete und nachweisbare physikalische Effekt in Betracht kommt. Vorteilhafterweise ist diese charakteristische Wechselwirkung mittels eines Auger-Elektronendetektors, eines Rückstreuelektronendetektors, eines Röntgenstrahlungs-detektors oder eines Fluoreszenzstrahlungsdetektors nachweisbar. Ein solcher Detektor kann auf der der Strahlformungseinrichtung zugewandten Seite der Maske aber auch auf der von der Strahlformungseinrichtung abgewandten Seite der Maske angeordnet sein.

Vorteilhafterweise ist der Markierungsbereich durch eine Schicht aus dem Markierungsmaterial gebildet, welche auf der Stirnseite des Stegs aufgebracht ist, die von der Membranschicht abgewandt ist. Diese Ausführung ist insbesondere dann vorteilhaft, wenn die Stege auf der der Strahlformungseinrichtung zugewandten Seite der Maske angeordnet sind.

Diese Ausführung ist ferner dann vorteilhaft, wenn die Stege durch ein Ätzverfahren aus einem Substrat gebildet werden, wobei vor dem Ätzen auf dem Substrat eine die Geometrie der Stege wiedergebende Maske aufgebracht wurde. Bei geeigneter Wahl des Maskenmaterials kann dieses nach dem Herausätzen der Stege auf diesen verbleiben, um dann weiterhin als Markierungsmaterial zu wirken.

Alternativ hierzu kann der Markierungsbereich auch durch eine zwischen der Membranschicht und dem Steg angeordnete Markierungsschicht gebildet sein. Dies ist insbesondere dann vorteilhaft, wenn die Stege durch ein Ätzverfahren hergestellt werden, bei welchem zwischen der Membranschicht und dem Material, aus dem die Stege zu ätzen sind, eine Ätz-Stopp-Schicht vorgesehen ist. Diese Ätz-Stopp-Schicht wird nach dem Ätzvorgang zur Bildung der Stege im Zwischenraum zwischen den Stegen entfernt, bleibt jedoch zwischen Stegen und Membranschicht bestehen. Bei geeigneter Wahl des Materials für die Ätz-Stopp-Schicht können die verbleibenden Bereiche der Ätz-Stopp-Schicht zwischen den Stegen und der Membranschicht dann nachfolgend als Markierungsbereiche verwendet werden.

Alternativ hierzu können die Markierungsbereiche jedoch auch auf der den Stegen abgewandten Seite der Membranschicht ausgebildet sein. Diese Ausführung ist insbesondere dann vorteilhaft, wenn die Stege selbst auf der Seite der Maske angeordnet sind, die von der Strahlformungseinrichtung abgewandt ist.

Eine besonders einfache Art der Strahlführung ergibt sich vorteilhafterweise dann, wenn der Markierungsbereich durch den Steg selbst gebildet ist.

Unter einem ersten weiteren Aspekt der Erfindung ist vorgesehen, dass die Positionier-Bewegungseinrichtung auf das Messsignal anspricht, um Abweichungen von der vorbestimmten Bahn zu reduzieren. Es ist dann möglich, den Projektionsstrahlquerschnitt so über die Maske zu führen, dass möglichst keine geladenen Teilchen des Projektionsstrahls unerwünschterweise auf die Stege treffen.

Hierbei ist es vorteilhaft, dass der Projektionsstrahlquerschnitt in Richtung quer zur Erstreckungsrichtung der Stege eine Breite aufweist, die im wesentlichen der lichten Weite zwischen benachbarten Stegen entspricht. Ist dann insbesondere der Markierungsbereich so angeordnet, dass er, gesehen in Strahlrichtung, mit den Stegen zusammenfällt, so registriert der Sensor im Wesentlichen keine Wechselwirkung der geladenen Teilchen mit dem Markierungsbereich, wenn der Projektionsstrahlquerschnitt auf der vorbestimmten Bahn relativ zur Maske positioniert ist. Sobald der Strahl von seiner vorbestimmten Bahn abweicht, wird der Projektionsstrahlquerschnitt dann den Markierungsbereich berühren und die hierfür charakteristische Wechselwirkung mit dem Markierungsmaterial erzeugen, welche von dem Sensor nachweisbar ist. Die Positionier-Bewegungseinrichtung ist dann in der Lage, eine entsprechende Korrektur an der Bahn des Strahls hin zu der vorbestimmten Bahn durchzuführen.

Vorteilhafterweise sind zwei verschiedene Arten von Markierungsbereichen ausgebildet, welche durch unterschiedliche Markierungsmaterialien mit durch den Sensor unterscheidbarer Wechselwirkung mit den geladenen Teilchen gebildet sind. Wird die eine Art von Markierungsbereich in Projektion in Strahlrichtung über dem einen Steg ausgebildet und die andere Art von Markierungsbereich in Projektion über dem hierzu benachbarten Steg ausgebildet, so kann bei zwischen diesen beiden Stegen bewegtem Strahl unterschieden werden, ob die Bahn in die Richtung des einen Steges oder in die Richtung des anderen Steges von der vorbestimmten Bahn abweicht, so dass die Positionier-Bewegungseinrichtung eine entsprechend gerichtete Korrektur besser durchführen kann.

Vorteilhafterweise erzeugt die Strahlformungseinrichtung neben dem Projektionsstrahl noch wenigstens einen Positionierungshilfsstrahl, der zur Wechselwirkung mit dem Markierungsbereich vorgesehen ist. Bei ordnungsgemäß positioniertem Projektionsstrahlquerschnitt zwischen benachbarten Stegen ist der Hilfsstrahlquerschnitt dann relativ zu dem Projektionsstrahlquerschnitt derart angeordnet, dass er auf einen Steg fällt. Der Markierungsbereich ist dann vorteilhafterweise in Projektion in Strahlrichtung über den Stegen angeordnet, so dass die Wechselwirkung mit dem Markierungsmaterial bei ordnungsgemäß positioniertem Projektionsstrahl nicht mit dem Projektionsstrahl selbst, sondern durch den Hilfsstrahl erfolgt. Die Position des Projektionsstrahls kann damit selbst dann erfasst werden, wenn dieser nicht von seiner vorbestimmten Bahn abweicht. Andererseits trifft der Hilfsstrahl in einem Bereich auf die Maske, welche für die Abbildung des Musters auf das Substrat nicht verwendet wird. Aus diesem Bereich werden die geladenen Teilchen des Hilfsstrahls durch den Steg oder/und den in dessen Projektion vorgesehenen Markierungsbereich gestreut und tragen aus diesem Grund ebenfalls im wesentlichen nicht oder nur geringfügig zur Belichtung der strahlungsempfindlichen Schicht bei.

Der Positionierungshilfsstrahl weist vorteilhafterweise eine Gestalt auf, die sich, gesehen in eine Richtung quer zur Erstreckungsrichtung der vorbestimmten Bahn, kontinuierlich verjüngt. Hierdurch trifft bei zunehmender Abweichung der Bahn des Projektionsstrahlquerschnitts von seiner vorbestimmten Bahn ein zunehmend größerer Bereich des Positionierungshilfsstrahls auf den Markierungsbereich, so dass die Stärke des Messsignals mit zunehmender Abweichung der Bahn von der vorbestimmten Bahn zu- bzw. abnimmt. Hierdurch ist das Messsignal zur Korrektur der Bahn durch die Positionier-Bewegungseinrichtung besonders gut geeignet.

Vorteilhafterweise erzeugt die Strahlformungseinrichtung zwei Positionierungshilfsstrahlen, deren Abstand in Maskenebene derart bemessen ist, dass beide Hilfsstrahlen bei ordnungsgemäß positioniertem Projektionsstrahl auf jeweils verschiedene Stege, nicht jedoch in den Bereich zwischen den Stegen treffen.

Insbesondere hierbei ist es vorteilhaft, wenn der Markierungsbereich, gesehen in Strahlrichtung, innerhalb der projizierten Fläche des Stegs und mit einem vorbestimmten Abstand von deren Rändern angeordnet ist. Dann kann, insbesondere in Verbindung mit dem sich verjüngenden Hilfsstrahlquerschnitt, die tatsächliche Position des Projektionsstrahls besonders präzise erfasst werden.

Alternativ hierzu ist es auch möglich, den Markierungsbereich zwischen benachbarten Stegen und nahe einem der beiden benachbarten Stege anzuordnen. Hierbei sollte der Markierungsbereich allerdings die Zahl der ungestreut durch die Maske tretenden geladenen Teilchen nur unwesentlich reduzieren. In Verbindung mit einem Projektionsstrahlquerschnitt, der sich in einem Bereich nahe der Stege hin zu den Stegen verjüngt, ist damit auch mit dem zwischen den Stegen angeordneten Markierungsbereich eine Erfassung der Position des Projektionsstrahls möglich.

Vorteilhafterweise ist ferner ein Maskierungsbereich vorgesehen, der, gesehen in Projektion parallel zu dem Teilchenstrahl, mit dem Markierungsbereich wenigstens teilweise überlappt. Aufgabe des Maskierungsbereichs ist es, geladene Teilchen, welche durch den Markierungsbereich geringfügig gestreut wurden, soweit zu streuen, dass sie nicht auf die strahlungsempfindliche Schicht abgebildet werden. Geladene Teilchen, die durch die Wechselwirkung mit dem Markierungsbereich nicht gestreut oder nur um einen kleinen Streuwinkel gestreut wurden, erhalten also durch die Wechselwirkung mit dem Maskierungsbereich einen so großen Streuwinkel, dass sie nicht so auf die zu belichtende Schicht abgebildet werden, wie dies mit den geladenen Teilchen geschieht, die lediglich die Membranschicht durchsetzten. Hierzu ist der Maskierungsbereich vorzugsweise aus einem Material gebildet, welches die geladenen Teilchen stärker streut als die Membranschicht oder/und das Markierungsmaterial oder/und der Stützsteg.

Hierbei ist es weiter bevorzugt, dass das Material des Maskierungsbereichs das Material des Streubereichs umfasst, insbesondere können Maskierungsbereiche und Streubereiche in einem gemeinsamen Fertigungsschritt der Maske hergestellt werden.

Im Folgenden werden Ausführungsbeispiele der Erfindung anhand von Zeichnungen näher erläutert. Hierbei zeigt:
- Figur 1: eine Projektionsvorrichtung gemäß dem Stand der Technik;
- Figur 2: eine Darstellung einer erfindungsgemäßen Maske in Draufsicht sowie eine Erläuterung von Richtungen der Strahlführung;
- Figur 3: eine Vergrößerung der Figur 2 zur Erläuterung der Führung eines Projektionsstrahlquerschnitts entlang einer vorbestimmten Bahn;
- Figur 4: eine erfindungsgemäße Projektionsvorrichtung;
- Figur 5: eine Darstellung der Anordnung eines bei der Projektionsvorrichtung der Figur 4 verwendeten Projektionsstrahlquerschnitts bezüglich Markierungsbereichen;
- Figur 6: eine Variante der Erfindung mit Positionierungshilfsstrahl;
- Figur 7: eine Variante der in Figur 4 dargestellten Maske;
- Figur 8: eine weitere Ausführungsform der Maske zur Verwendung mit Positionierungshilfsstrahl gemäß Figur 6;
- Figur 9: eine Variante der Maske zur Verwendung mit Positionierungshilfsstrahl gemäß Figur 6;
- Figur 10: eine weitere Variante der Erfindung mit Positionierungshilfsstrahl;
- Figur 11: eine Ausführungsform der Erfindung zum Erfassen eines Bahnendes;
- Figur 12: eine Variante der in Figur 11 dargestellten Ausführungsform zur Erfassung des Bahnendes und
- Figur 13: eine Variante der in Figur 5 dargestellten Ausführungsform.
- Figur 14: eine weitere Variante der in Figur 4 gezeigten Maske.

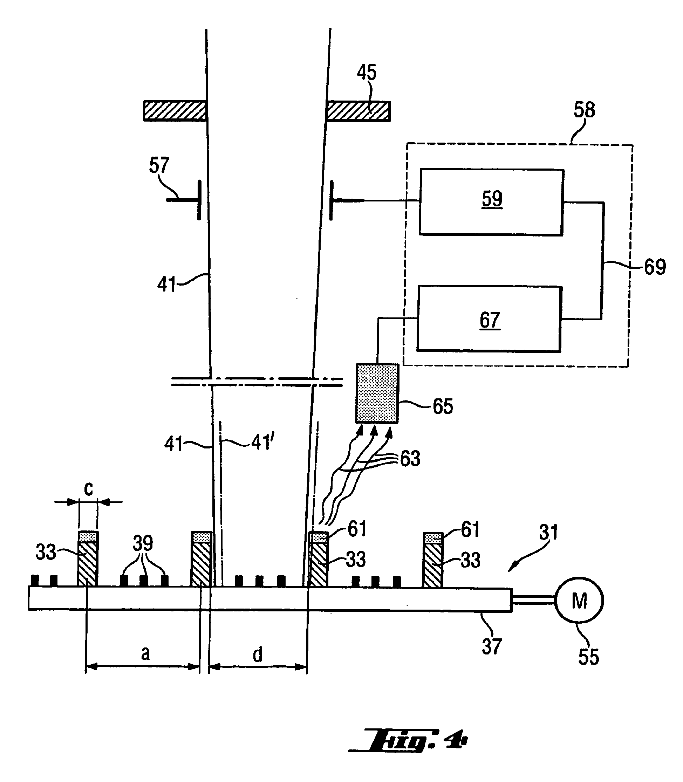

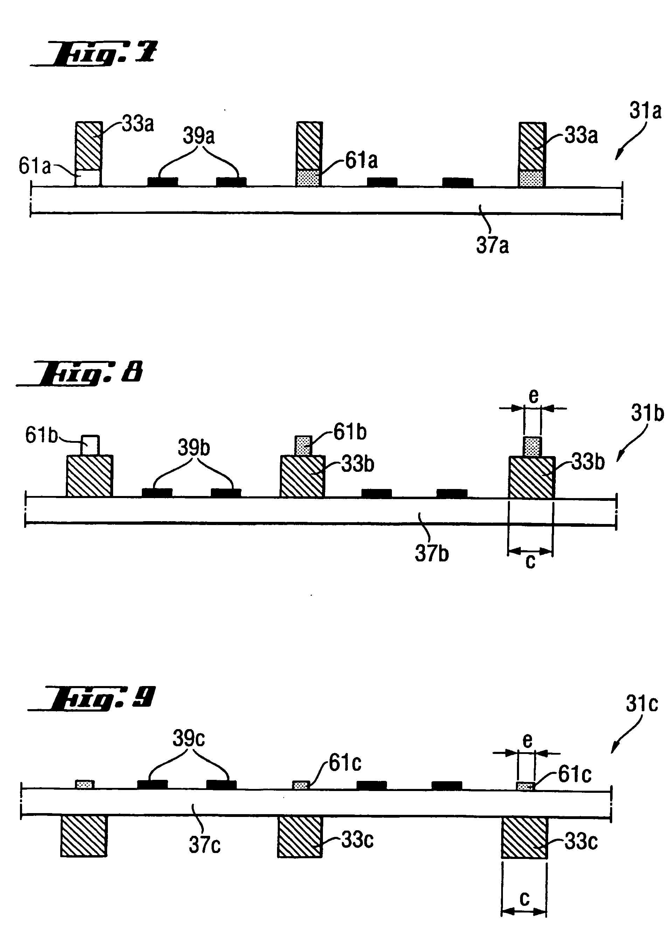

Der Aufbau einer erfindungsgemäßen Maske 31 ist aus den Figuren 2 und 4 ersichtlich, wobei Figur 2 die Maske in Draufsicht und Figur 4 die Maske 31 im Querschnitt entlang einer Linie IV-IV in Figur 2 darstellt.

Die Maske 31 umfasst ein ebenes regelmäßiges und rechtwinkliges Gerüst aus längsverlaufenden Stegen 33 und quer hierzu sich erstreckenden Stegen 35. Die Stege 33 sind mit einem regelmäßigen Abstand a von beispielsweise 1.1 mm bis 1.5 mm voneinander angeordnet. Die Stege 35 sind mit einem Abstand b voneinander angeordnet, der größer ist als der Abstand a der Stege 33 voneinander. Das Gerüst aus den Stegen 33, 35 trägt eine Membranschicht 37, welche Elektronen vergleichsweise wenig streut. Das Muster der Maske 31 wird durch Streubereiche 39 gebildet, die zwischen den Stegen 33, 35 auf der Membranschicht 37 angeordnet sind.

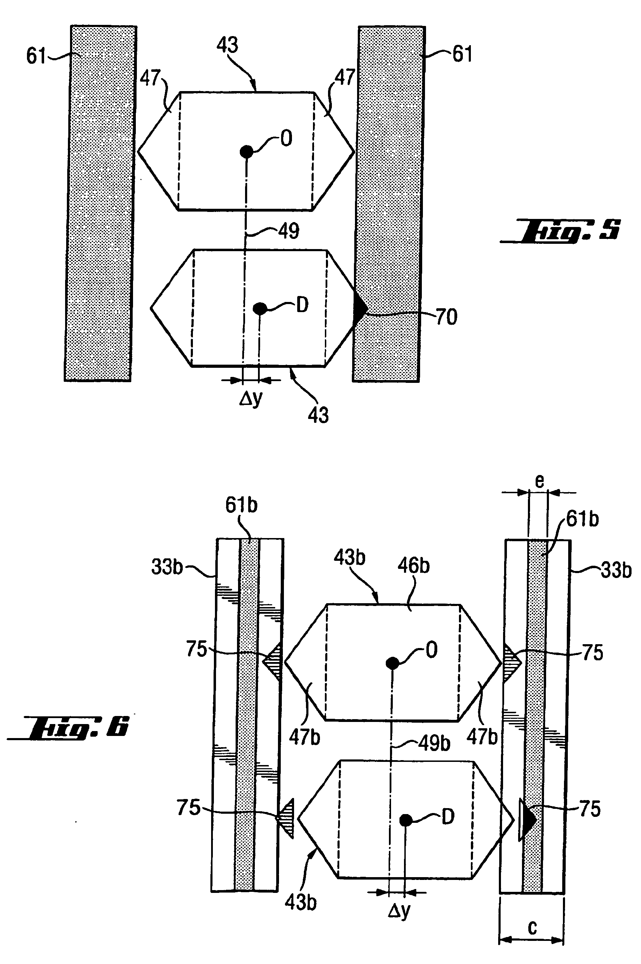

Auf die Maske 31 ist, wie aus Figur 4 ersichtlich, ein durch eine nicht dargestellte Elektronenstrahlquelle erzeugter Elektronenstrahl 41 mit beispielsweise einer Energie von 100 keV gerichtet, dessen Strahlquerschnitt 43 (vergl. Figur 3) in der Ebene der Maske 31 durch eine Strahlformungseinrichtung 45 bestimmt ist. Die Strahlformungseinrichtung 45 kann beispielsweise durch eine Blendenvorrichtung gebildet sein. Wie aus Figur 3 ersichtlich, ist der Projektionsstrahlquerschnitt 43 trapezförmig und umfasst einen zentralen rechteckigen Bereich 46 und zwei an gegenüberliegenden Seiten des Rechtecks 46 angrenzende dreieckige Bereiche 47.

Eine Positionier-Bewegungseinrichtung bewegt den Strahlquerschnitt 43 zwischen benachbarten Stegen 33 in eine Richtung A (Figur 2) geradlinig entlang von vorbestimmten Bahnen 49. Eine solche vorbestimmte Bahn 49 beginnt an einem Punkt 51 und endet an einem Punkt 53 derart, dass von dem Projektionsstrahlquerschnitt 43 der gesamte Bereich zwischen benachbarten Stegen 33 überstrichen wird. Ist der Projektionsstrahlquerschnitt an dem Punkt 53 angelangt, wird der Projektionsstrahl über die Elektronenstrahlquelle abgeschaltet, und der Projektionsstrahlquerschnitt überspringt einen Steg 33 in eine Richtung B quer zur Erstreckungsrichtung der Stege 33. Sodann gelangt er zu einem neuen Startpunkt 51 zwischen dem nächsten benachbarten Stegpaar 33 und wird dann wiederum gleichförmig zu einem weiteren Endpunkt 53 bewegt. Auf diese Weise werden nach und nach sämtliche Bereiche der Membranschicht 37 zwischen den Stegen 33, 35 durch den Strahlquerschnitt 43 abgetastet.

Die Positionier-Bewegungseinrichtung umfasst eine elektronenoptische Vorrichtung, die die Ablenkung des Strahls in Richtung A durchführt, sowie einen Antrieb 55, der die Maske relativ zu der Elektronenoptik gleichförmig in Richtung B bewegt. Ferner umfasst die Positionier-Bewegungseinrichtung eine weitere elektronenoptische Komponente 57, welche den Projektionsstrahl 41 ebenfalls in Richtung B derart ablenkt, dass sich der Projektionsstrahlquerschnitt 43 entlang der vorbestimmten Bahnen 49 zwischen den Stegen 33 und während der durch den Motor 55 getriebenen kontinuierlichen Bewegung der Maske 31 relativ zu der Elektronenoptik bewegt.

Weitere Details zu der Gestalt des Projektionsstrahlquerschnitts und der Maske 31 sowie deren Stegstruktur 33, 35 können dem oben genannten Weisbuch entnommen werden. Die Positionier-Bewegungseinrichtung weist ferner eine Steuereinrichtung 58 auf, welche einen Ablenksignalgenerator 59 umfasst, der die elektronenoptische Komponente 57 zur Ablenkung des Projektionsstrahls 41 in die Richtungen A und B ansteuert.

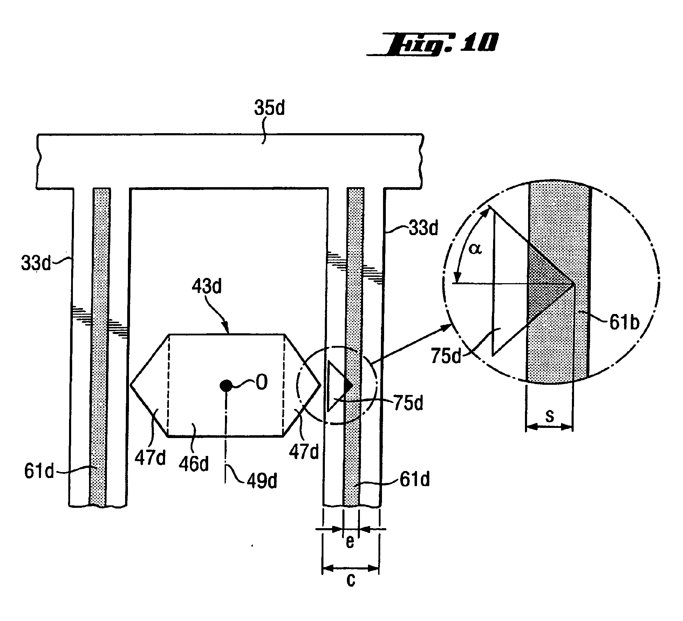

Die Spitzen der beiden dreieckigen Bereiche 47 des Projektionsstrahlquerschnitts 43 weisen bei der hier beschriebenen Ausführungsform in der Maskenebene einen Abstand voneinander auf, der einer lichten Weite d zwischen den mit dem Abstand a voneinander angeordneten Stegen 33 entspricht. Bei ordnungsgemäß auf der vorbestimmten Bahn 49 angeordnetem Projektionsstrahlquerschnitt mit Strahlschwerpunkt O (vergleiche Figur 5) treffen dann keine Elektronen des Projektionsstrahls 41 auf die Stege 33, wie dies in Figur 4 durch den Strahl 41 in durchgezogener Linie und in Figur 5 mit dem oberen Strahlquerschnitt dargestellt ist. Weicht der Projektionsstrahlquerschnitt von seiner vorbestimmten Bahn 49 um eine Strecke Δy ab, so treffen Elektronen aus einem der dreieckigen Bereiche 47 auf einen Steg 33, wie dies in Figur 4 durch einen mit einer gestrichelten Linie dargestellten Strahl 41' und in Figur 5 mit dem unteren Strahlquerschnitt mit Strahlschwerpunkt D dargestellt ist.

Um diese Abweichung von der vorbestimmten Bahn 49 zu erfassen, ist auf den von der Membranschicht 37 abgewandten Stirnseite der Stege 33 jeweils eine Markierungsschicht 61 angeordnet. Diese Markierungsschicht 61 ist aus einem Material gebildet, welches von den für die Membranschicht 37, die Streubereiche 39 und die Stege 33 verwendeten Materialien verschieden ist und bei Wechselwirkung mit den Elektronen des Projektionsstrahls eine charakteristische Röntgenstrahlung 63 erzeugt. Diese Röntgenstrahlung 63 wird von einem Röntgendetektor 65 erfasst. Der Ausgang des Röntgendetektors 65 ist mit einem in der Steuereinrichtung 58 vorgesehenen Energieanalysator 67 verbunden, der das Ausgangssignal des Detektors 65 filtert, um die charakteristische Röntgenstrahlung 63 von anderen, gegebenenfalls von dem Detektor 65 erfassten Strahlungskomponenten zu diskriminieren. Das von dem Energieanalysator 67 ausgegebene Signal ist somit im Wesentlichen proportional zur Zahl der auf die Stege 33 bzw. die Markierungsbereiche 61 treffenden Elektronen des Projektionsstrahls 41 und damit auch in etwa proportional zu der in Figur 5 mit 70 bezeichneten Fläche des Überlapps zwischen Strahlquerschnitt 43 und Markierungsbereich 61. Dieses Signal wird dem Ablenkgenerator 59 als Messsignal 69 zugeführt. Der Ablenksignalgenerator wertet das Messsignal 69 aus und steuert die elektronenoptische Komponente 57 derart an, dass das Signal 69 minimiert wird, um den Projektionsstrahlquerschnitt 43 auf der vorbestimmten Bahn 49 zu positionieren.

Die Maske 31 kann durch ein Ätzverfahren hergestellt werden, wie es in EP 0 953 876 A2 für eine herkömmliche Maske dargestellt ist. Es wird ein Substrat aus dem Material der Stege 33, 35 auf seiner einen Seite mit dem Material der Membranschicht 37 und auf seiner anderen Seite mit einem Maskenmaterial beschichtet. Das Maskenmaterial wird als ein Gitter ausgebildet, das der Geometrie der Stege 33, 35 entspricht.

In einem Ätzschritt wird das Substratmaterial in den Gitterzwischenräumen entfernt, so dass das unterhalb der Gittermaske verbleibende Substratmaterial die Stege 33, 35 bildet. Bei geeigneter Wahl des Materials für die Gittermaske kann dieses auf den Stegen 33 verbleiben, um die Streubereiche 61 zu bilden. Es kann das Material der Gittermaske allerdings auch abgetragen werden, woraufhin dann die Stege 33 auf ihrer von der Membranschicht 33 weg weisenden Stirnseiten mit den Markierungsbereichen 61 beschichtet werden.

Als Materialien für den Aufbau der Maske 31 können beispielsweise verwendet werden: Silizium für die Stege 33, 35, Silizium, Siliziumnitrid, Siliziumcarbid und Diamant für die Membranschicht 37, Titan, Chrom, Aluminium und Wolfram sowie deren Oxide und Legierungen davon für die Streubereiche 39. Für die Markierungsbereiche 61 kommen als schwere Elemente, welches insbesondere bezüglich ihres Röntgenspektrums von den für die Streubereiche 39 verwendeten Materialien unterscheidbar sind, Iridium, Platin, Gold und Blei sowie deren Oxide sowie als mittelschweres Element Germanium und dessen Zusammensetzungen in Betracht. Ferner sind für die Markierungsbereiche 61 leichte Materialien bevorzugt, da diese allgemein Elektronen nicht so stark streuen. Insbesondere sind hierbei Elemente bevorzugt, welche bei der Fertigung des Produkts, für welche die Belichtung mit den geladenen Teilchen eingesetzt wird, verträglich sind. Bei der Fertigung von Halbleitern auf Siliziumbasis ist hierbei insbesondere Germanium als Material für die Markierungsbereiche 61 bevorzugt. Ferner sind für die Markierungsbereiche 61 Materialien bevorzugt, welche durch Bestrahlung mit den geladenen Teilchen zur Szintillation angeregt werden. Derartige Materialien sind bekannt, beispielsweise zur Beschichtung von Sichtschirmen bei Transmissionselektronenmikroskopen, wie beispielsweise Phosphore. Als weitere Materialien für die Markierungsbereiche sind ebenfalls Aluminium, Titan, Vanadium und Germanium bevorzugt, die insbesondere bezüglich eines Detektor-Nachweises über Auger-Elektronen Vorteile aufweisen. Selbstverständlich sind auch andere Materialien und Materialkombinationen für die Herstellung der Maskenkomponenten denkbar.

Im Folgenden werden Varianten der vorangehend dargestellten Ausführungsformen der Erfindung erläutert. Hinsichtlich ihres Aufbaus und ihrer Funktion einander entsprechende Komponenten sind mit den für die Figuren 2, 3, 4 und 5 verwendeten Bezugszahlen, zur Unterscheidung jedoch jeweils mit einem zusätzlichen Buchstaben versehen. Zur Erläuterung wird jeweils auf die gesamte vorangehende Beschreibung Bezug genommen.

In Figur 7 ist eine Variante der in Figur 4 dargestellten Maske gezeigt. Die in Figur 7 gezeigte Maske 31a unterscheidet sich von der in Figur 4 dargestellten Maske dadurch, dass Markierungsbereiche 61a zwischen Stegen 33a und einer Membranschicht 37a angeordnet sind. Die Maske 31a kann durch Abwandlung des für die Maske der Figur 4 geschilderten Herstellungsverfahrens gefertigt werden. Bei einem solchen Verfahren wird nämlich vorteilhafterweise vor dem Aufbringen der Membranschicht auf das Substrat aus dem Stegmaterial auf dieses Substrat eine Ätz-Stopp-Schicht aufgebracht. Dieses dient dazu, dass beim Ätzen der Stege 33a aus dem Substrat nicht die Membranschicht durch den Ätzvorgang beschädigt wird. Die Ätz-Stopp-Schicht wird nach dem Herausätzen der Stege 33a in einem separaten Schritt entfernt, so dass zwischen den Stegen 33a die Membranschicht 37a freiliegt. Unter den Stegen 33a und der Membranschicht 37a ist das Material der Ätz-Stopp-Schicht allerdings durch die Stege 33a geschützt und bleibt somit bestehen. Bei geeigneter Wahl des Materials für die Ätz-Stopp-Schicht kann dieses verbleibende Material dann als Material für die Markierungsbereiche dienen, wenn es sich hinsichtlich seiner Wechselwirkung mit den Elektronen von den Materialien für die Membranschicht 37a, die Stege 33a und Streubereiche 39a unterscheidet.

Die in Figur 6 dargestellte Ausführungsform der Erfindung weist wiederum einen Projektionsstrahlquerschnitt 43b auf, der aus einem rechteckigen zentralen Bereich 46b und zwei an gegenüberliegenden Seiten des zentralen Bereichs 46b angeordnete dreieckige Bereiche 47b gebildet ist. Der Abstand der Spitzen der dreieckigen Bereiche 47b ist wiederum so gewählt, dass er einer lichten Weite zwischen benachbarten Stegen 33b entspricht. Bei dem in Figur 6 dargestellten oberen Projektionsstrahlquerschnitt 43b mit am Punkt O angeordnetem Strahlschwerpunkt auf der vorbestimmten Bahn 49b treffen somit keine Elektronen des Projektionsstrahlquerschnitts 43b auf die Stege 33b.

Der Elektronenstrahl der Figur 6 umfasst allerdings zwei Positionierungshilfsstrahlen 75, welche beidseits außerhalb des Projektionsstrahls 43b angeordnet sind. Die Positionierungshilfsstrahlen 75 können beispielsweise durch die in Figur 4 schematisch dargestellte Blendenvorrichtung 45 gemeinsam mit dem Projektionsstrahl 43b geformt werden. Diese Hilfsstrahlen 75 wirken mit Markierungsbereichen 61b zusammen, welche jeweils mittig auf den Stegen 33b angeordnet sind und eine Breite e aufweisen, die geringer ist als die Breite c der Stege 33b von beispielsweise 200 µm. Bei auf der vorbestimmten Bahn mit Strahlschwerpunkt am Ort O angeordnetem Projektionsstrahlquerschnitt 43b treffen die Hilfsstrahlen 75 auf den Bereich der Stirnseiten der Stege 33b, welche nicht von dem Markierungsbereich 61b bedeckt sind.

Weicht der Projektionsstrahlquerschnitt allerdings von der vorbestimmten Bahn um eine Strecke Δy ab, wie dies für den in der Figur 6 unteren Projektionsstrahlquerschnitt 43b mit Strahlschwerpunkt D dargestellt ist, so trifft der in der Figur 6 rechte Hilfsstrahl 75 auf den Markierungsbereich 61b. Dies führt zu einer Wechselwirkung der Elektronen des Hilfsstrahls 75 mit dem Material des Markierungsbereichs 61b, welche Wechselwirkung von einem wie in Figur 4 dargestellten Sensor erfasst werden kann, um über eine Elektronenoptik die Position des Projektionsstrahlquerschnitts zu korrigieren. Die Korrektur erfolgt dabei derart, dass das Messsignal des Sensors minimiert wird, d.h. derart, dass keine Elektronen der Hilfsstrahlen 75 auf die Markierungsbereiche 61b fallen.

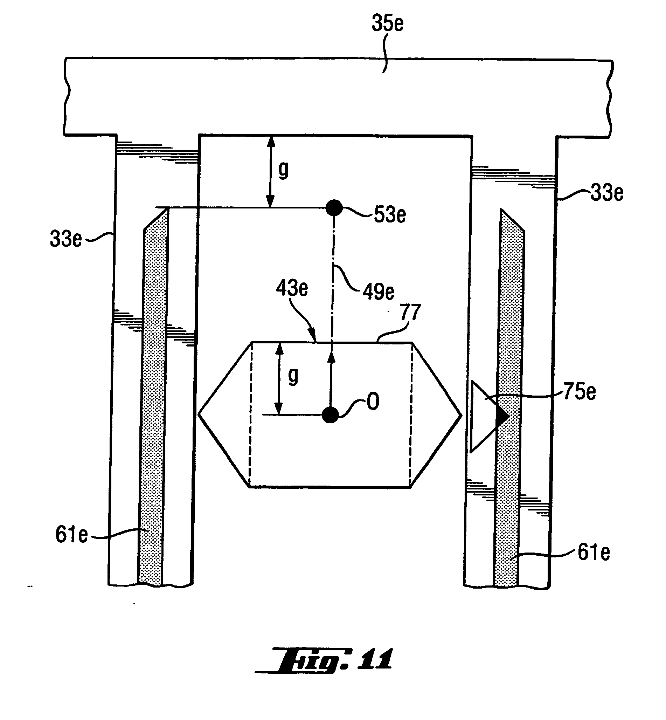

Eine für die Ausführungsform der Figur 6 verwendbare Maske 31b ist in Figur 8 im Querschnitt dargestellt. Die Maske 31b der Figur 8 ist der in Figur 4 dargestellten Maske ähnlich, allerdings mit dem Unterschied, dass die Markierungsbereiche 61b nicht die gesamte Stirnfläche der Stege 33b bedecken. Die Maske 31b kann in einem zur Fertigung der Maske der Figur 4 ähnlichen Verfahren hergestellt werden, wobei allerdings in beispielsweise einem weiteren Ätzschritt das zur Bildung des Markierungsbereichs 61b verwendete Material derart abgetragen wird, dass die Markierungsbereiche 61b mit ihrer Breite e bestehen bleiben.

Eine weitere Ausführungsform für eine Maske 31c mit Markierungsbereichen 61c, deren Breite e geringer ist als eine Breite c von Stegen 33c, ist in Figur 9 gezeigt. Diese Maske ist ebenfalls in einem für die Fertigung der in Figur 4 dargestellten Maske verwendeten Verfahren herstellbar, wobei in einem zusätzlichen Schritt die Markierungsbereiche 61c auf der Membranschicht 37c abgeschieden werden.

In Figur 10 ist eine Variante der in Figur 6 dargestellten Ausführungsform gezeigt. Auch hier weist ein Projektionsstrahlquerschnitt 43d eine Gestalt derart auf, dass Spitzen von Dreiecken 47b bei ordnungsgemäßer Positionierung des Strahlschwerpunkts O auf einer vorbestimmten Bahn 49d Stege 33d der Maske nicht berühren. Es sind ebenfalls Markierungsbereiche 61d vorgesehen, welche in Projektion in Strahlrichtung mit ihrer Breite e nur einen Teil der Breite c der Stege 33d abdecken.

Ein Positionierungshilfsstrahl mit seinem Hilfsstrahlquerschnitt 75d in Maskenebene ist bezüglich dem Projektionsstrahlquerschnitt 43d derart angeordnet, dass bei ordnungsgemäß positioniertem Projektionsstrahlquerschnitt 43d ein Teil des Hilfsstrahls 75d auf den Markierungsbereich 61d trifft. Dies führt zu einer Wechselwirkung von Elektronen des Hilfsstrahls 75d mit dem Material des Markierungsbereichs 61d, welche von dem Sensor erfasst wird und über den Energieanalysator als Soll-Messsignal dem Ablenksignalgenerator zugeführt wird.

Der Hilfsstrahlquerschnitt 75d weist eine dreieckige Gestalt derart auf, dass sich sein Querschnitt 75d in eine Richtung quer zur Erstreckungsrichtung der Stege 33d verjüngt. Folglich ändert sich bei einer Abweichung des Projektionsstrahlschwerpunkts vom Punkt O die Fläche, mit der der Hilfsstrahl 75d auf den Markierungsbereich 61d trifft, wie dies aus der in die Figur 10 integrierte Vergrößerungsdarstellung deutlich wird: die Zahl der Wechselwirkungen ist proportional zu der Fläche, mit der der Hilfsstrahlquerschnitt 75d den Markierungsbereich 61b überlappt, wobei für diese Fläche F gilt: F = s² x tan α, wobei der Öffnungswinkel der Dreiecksgestalt des Hilfsstrahls 75d gleich 2 α ist.

Der Ablenkgenerator wertet das entstehende Messsignal aus und steuert dann die elektronenoptische Komponente (Bezugszeichen 57 in Figur 4) derart an, daß das Messsignal auf einem vorbestimmten Wert gehalten wird, um den Projektionsstrahlquerschnitt 73d auf der vorbestimmten Bahn 49d zu positionieren.

In Figur 11 ist eine weitere Ausführungsform der Erfindung dargestellt. Diese ist der in Figur 10 gezeigten Ausführungsform sehr ähnlich, allerdings wird hier ein Markierungsbereich 61e zusammen mit einem Positionierungshilfsstrahl 75e nicht nur zur Positionierung des Strahlschwerpunkts O des Projektionsstrahlquerschnitts 43e auf einer vorbestimmten Bahn 49e verwendet. Hilfsstrahl 75e und Markierungsbereich 61e werden hier weiterhin dazu verwendet, um das Erreichen des Endpunkts 53e (vgl. Figur 3) bei der Bewegung des Projektionsstrahls 43e entlang der vorbestimmten Bahn 49e zu bestimmen.

Der Endpunkt 53e ist mit einem Abstand g von einem Quersteg 35e angeordnet, der dem Abstand des Strahlschwerpunkts O von einer Vorderfront 77 des Projektionsstrahlquerschnitts 43e entspricht.

Der Markierungsbereich 61e erstreckt sich entlang des Stegs 33e in Richtung zu dem Quersteg 35e hin , endet allerdings mit einem Abstand vor dem Steg 35e, der ebenfalls dem Abstand g entspricht, derart, dass bei Anordnung des Projektionsstrahlschwerpunkts O auf dem Endpunkt 53e gerade kein Überlapp zwischen dem Hilfsstrahl 75e und dem Markierungsbereich 61e stattfindet. Entsprechend ist die Zahl der Wechselwirkungen zwischen den Elektronen des Hilfsstrahls 75e und dem Markierungsbereich 61e auf null abgesunken, was über den Sensor erfasst werden kann und unter anderem als Signal dafür eingesetzt werden kann, um den Projektionsstrahl an einem Endpunkt 53e seiner vorbestimmten Bahn 49e abzuschalten.

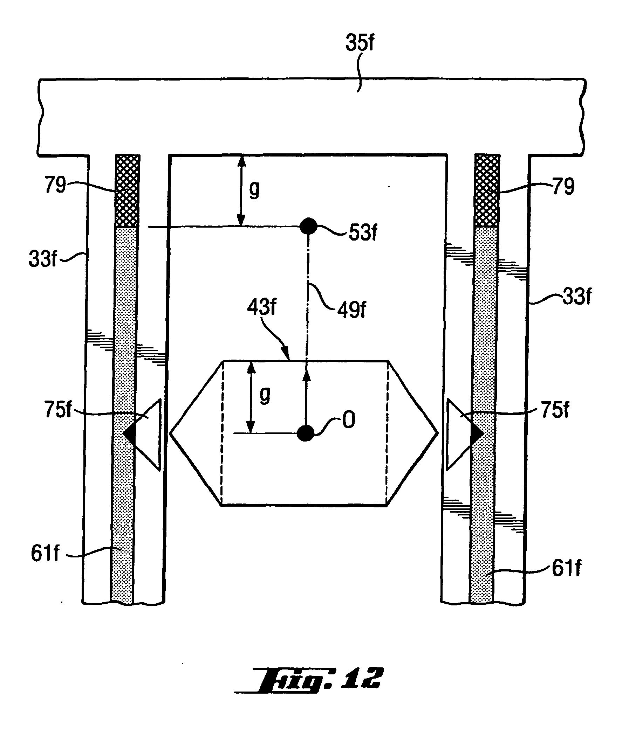

Eine der Ausführungsform der Figur 11 ähnliche weitere Ausführungsform der Erfindung ist in Figur 12 dargestellt.

Hier sind neben einem Projektionsstrahl 43f zwei beidseits desselben angeordnete Positionierungshilfsstrahlen 75f vorgesehen. Die Positionierungshilfsstrahlen 75f laufen während der Bewegung des Projektionsstrahls 43f auf der vorbestimmten Bahn 49f auf Markierungsstreifen 61f, um über die Wechselwirkung der Elektronen des Hilfsstrahls 75f mit dem Markierungsstreifen 61f den Strahlschwerpunkt O auf der vorbestimmten Bahn 49f, wie vorangehend beschrieben, zu positionieren.

An den an Querstege 35f angrenzenden Enden der Stege 33f sind jeweils Endmarkierungen 79 derart angebracht, dass diese von den Hilfsstrahlen 75f getroffen werden, sobald sich der Strahlschwerpunkt O dem Endpunkt 53f annähert. Die Endmarkierungen 79 sind aus einem Material gebildet, dessen Wechselwirkung mit dem Elektronenstrahl sich von der Wechselwirkung mit den Materialien unterscheidet, wie sie für die Bildung der Stege 33f, 35f, die Membranschicht, die Streubereiche und die Markierungsschicht 61f verwendet werden. Allerdings ist auch diese Wechselwirkung von dem Sensor oder einem separat hierfür vorgesehenen Sensor nachweisbar, so dass das Erreichen der Endposition 53f ähnlich wie bei der in Figur 11 dargestellten Ausführungsform erfasst werden kann.

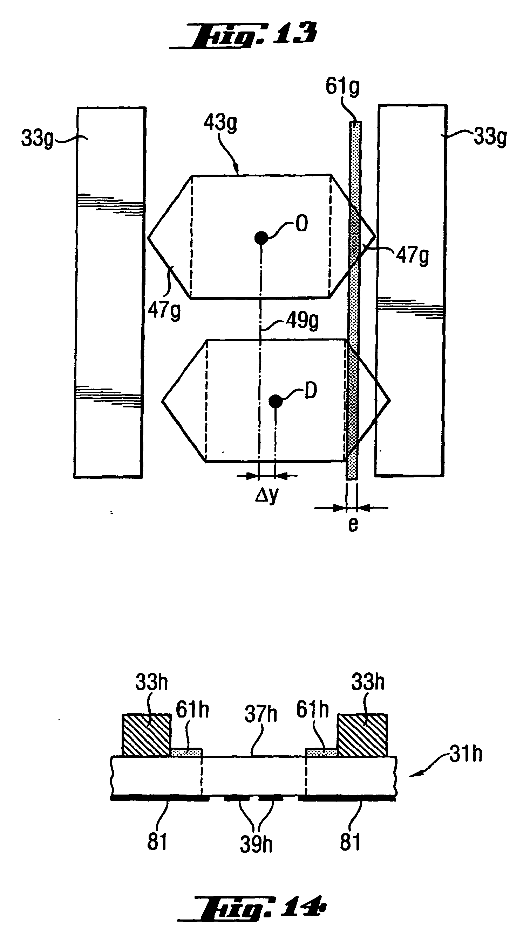

In Figur 13 ist eine Variante der in Figur 5 dargestellten Ausführungsform gezeigt. Im Unterschied zu der Ausführungsform der Figur 5 ist hier ein Markierungsbereich 61g nicht in Projektion über einen Steg 33g angeordnet, sondern im Bereich zwischen benachtbarten Stegen 33g, und zwar derart, daß ein Projektionsstrahlquerschnitt 43g mit ordnungsgemäß auf einer vorbestimmten Bahn 49g positioniertem Strahlschwerpunkt O mit seinem sich quer zur Erstreckungsrichtung der Bahn 49g verjüngenden Teil, daß heißt, mit seinem dreieckigen Bereich 47g, mit dem Markierungsstreifen 61g überlappt. Die Fläche der Überlappung ist hierbei abhängig von einer Abweichung Δy des Strahlschwerpunktes O von der vorbestimmten Bahn 49g und vergrößert sich, wie dies in Figur 13 durch den unteren Strahlquerschnitt mit Schwerpunkt D dargestellt ist, wenn dieser nach rechts von der vorbestimmten Bahn abweicht. Mit Änderung der Überlappungsfläche ändert sich auch die Anzahl der Wechselwirkungen zwischen den Elektronen des Strahls mit dem Material des Markierungsbereichs 61g, was über den Sensor erfaßt wird und zur Korrektur der Bahn des Strahlquerschnitts verwendet wird.

Da bei diesem Ausführungsbeispiel der Markierungsbereich zwischen den Stegen angeordnet ist, daß heißt in einem Bereich, welcher für die Bildung des Musters der Maske durch Streubereiche (Bezugszeichen 39 in Figur 4) verwendet wird, ist hier darauf zu achten, daß die Streuung der Elektronen durch das Material des Markierungsbereichs 61g so gering ist, daß eine Störung der Abbildung des Musters auf das Substrat weitgehend vermieden ist. Allerdings erfolgen dennoch ausreichend viele Wechselwirkungen, die über den Sensor erfaßbar sind, um die Korrektur der Strahlführung, wie vorangehend beschrieben, durchzuführen.

Als weitere Ausführungsform der Erfindung ist es möglich, für die beiden in Figur 5 dargestellten Markierungsbereiche 61 verschiedene Materialien vorzusehen, die sich hinsichtlich ihrer Wechselwirkung mit den Elektronenstrahlen unterscheiden. Dadurch kann über einen geeigneten Sensor oder ein Paar von Sensoren festgestellt werden, ob der Strahlschwerpunkt des Projektionsstrahls 43 nach rechts oder nach links von seiner vorbestimmten Bahn 49 abweicht. Eine derartige Maske ist herstellbar, indem für die Stege 33 die beiden Materialen abwechselnd verwendet werden, also jeder zweite Steg aus dem selben Material gebildet ist.

Eine weitere Variante der in Figur 4 dargestellten Maske kann dadurch gefertigt werden, daß das Markierungsmaterial dem für die Stege verwendeten Material zugesetzt ist beispielsweise durch das Dotieren oder Implantieren. Damit bilden die Stege selbst die Markierungsbereiche.

In Figur 14 ist eine weitere Variante der in den Figuren 4, 7, 8 und 9 dargestellten Masken schematisch gezeigt. Die in Figur 14 gezeigte Maske 31h unterscheidet sich von den in den vorangehenden Figuren gezeigten Masken im Wesentlichen dadurch, dass ein Markierungsbereich 61h, gesehen in Projektion in Strahlrichtung, nicht mit einem Steg 33h überlappt, sondern neben diesem auf einer Membranschicht 37h angeordnet ist.

Hierbei wird vorzugsweise als ein Bereich der durch geladene Teilchen auf die zu belichtende Schicht abgebildet wird, der Bereich zwischen benachbarten Markierungsbereichen 61h verwendet, also ein Bereich, der eine der lichten Weite zwischen den in Figur 14 dargestellten Markierungsbereichen 61h entsprechende oder geringere Breite aufweist.

Diese Maske kann zusammen mit Projektionsstrahlquerschnitten verwendet werden, wie sie vorangehend beschrieben wurden. Insbesondere kann eine Abstimmung zwischen den Markierungsbereichen 61h und dem Projektionsstrahlquerschnitt eingesetzt werden, wie sie in Zusammenhang mit Figur 5 erläutert wurde. Dort weist der Projektionsstrahlquerschnitt eine Breite auf, die der lichten Weite zwischen den Markierungsbereichen 61h entspricht. Die Strahlführung erfolgt dann derart, dass der Detektor 65 der Figur 4 ein Detektionssignal von im wesentlichen Null erfasst, wenn der Projektionsstrahlquerschnitt in seiner Sollposition bezüglich der Maske angeordnet ist.

Die Abstimmung des Projektionsstrahlquerschnitts auf die Maske der Figur 14 kann allerdings auch in der in Zusammenhang mit Figur 6 erläuterten Weise erfolgen, wobei der Projektionsstrahlquerschnitt seitlich angeordnete Hilfsstrahlen aufweist, die zur Erzeugung des Signals für den Detektor 65 vorgesehen sind und wobei die Strahlführung dann vorzugsweise derart erfolgt, dass das von dem Detektor 65 erzeugte Messsignal auf einem vorbestimmten konstanten Wert gehalten wird.

Ferner kann die Abstimmung auch derart erfolgen, wie dies im Zusammenhang mit Figur 13 erläutert wurde, wobei der Projektionsstrahlquerschnitt mit seinen sich seitlich verjüngenden Bereichen auf die Markierungsbereiche 61h fällt und wiederum die Strahlführung derart erfolgt, dass das Detektionssignal des Detektors 65 auf einem vorbestimmten konstanten Wert gehalten wird.

Ferner ist auch vorgesehen, dass für jeweils benachbarte Markierungsbereiche 61h der Figur 14 unterschiedliche Materialien eingesetzt werden, um eine Abweichung der Strahlführung in die eine oder andere Richtung mittels Detektoren erfassen zu können.

Die Maske 31h der Figur 14 weist ferner Maskierungsbereiche 81 auf, welche, gesehen in Projektion parallel zum Teilchenstrahl, mit den Markierungsbereichen 61h überlappen. Die in Figur 14 dargestellten Maskierungsbereich 81 erstrecken sich sogar in Projektion parallel zu dem Teichenstrahl über die Markierungsbereiche 61h hinaus und überlappen auch mit den Stegen 33h. Die Maskierungsbereiche 81 haben die Aufgabe, geladene Teilchen, welche durch die Markierungsbereiche 61h oder die Stege 33h nicht oder geringfügig gestreut wurden, soweit zerstreuen, dass sie nicht auf die zu belichtende Schicht abgebildet werden, wie dies für den Strahl 13 in Figur 1 erläutert wurde.

Hierzu wird für die Maskierungsschicht 81 das gleiche Material verwendet, wie für Streubereiche 39h auf der Membran 37h.

Die Maskierungsbereiche 81 und die Streubereiche 39h können in einem gemeinsamen Fertigungsschritt geformt werden, wie dies für die Streubereiche in den vorangehend beschriebenen Ausführungsbeispiel bereits erläutert wurde.

Bei den vorangehend insbesondere in Zusammenhang mit den Figuren 4, 7, 8, 9 und 14 beschriebenen Masken sind die Stege bezüglich der Membranschicht jeweils auf der der Strahlformungsrichtung zuweisenden Seite angebracht. Es ist jedoch gleichfalls möglich, die Stege bezüglich der Membranschicht auf der entgegengesetzten Seite, das heißt der von der Strahlformungsrichtung wegweisenden Seite, anzuordnen.

Ferner ist es möglich, die Markierungsbereiche auf der der Strahlformungsrichtung zuweisenden Seite des Stützstegs oder auf der Membranschicht selbst anzuordnen. Hierbei wiederum ist vorgesehen, dass die Markierungsschicht zwischen Membranschicht und Stützsteg angeordnet ist, wie dies insbesondere im Zusammenhang mit Figur 7 erläutert wurde, oder es ist vorgesehen, dass die Markierungsschicht auf der Membranschicht auf der dem Stützsteg gegenüberliegenden Seite angeordnet ist, wie dies insbesondere im Zusammenhang mit Figur 9 erläutert wurde.

Ferner ist es möglich, dass die Markierungsschicht, gesehen in Projektion parallel zu dem Teilchenstrahl, mit der Grundfläche des Stegs überlappt, wobei die Markierungsbereiche sich über die gesamte Breite des Stützstegs erstrecken können, wie dies insbesondere in Zusammenhang mit den Figuren 4 und 7 erläutert wurde, oder wobei die Markierungsbereiche eine Breite aufweisen, die geringer ist als die Breite der Stützstege, wie dies insbesondere in Zusammenhang mit den Figuren 8 und 9 erläutert wurde.

Ferner können die Markierungsbereiche, in Projektion parallel zu dem Teichenstrahl auch neben dem Stützsteg angeordnet sein, und zwar mit Abstand von diesem, wie dies besonders in Zusammenhang mit Figur 13 erläutert wurde, oder direkt angrenzend an diesem, wie dies in Zusammenhang mit Figur 14 erläutert wurde.

Bei den in den Figuren 4, 7, 8 und 9 dargestellten Ausführungsformen sind die Streubereiche auf der der Strahlformungseinrichtung zugewandten Seite der Membranschicht angeordnet. Es ist bei diesen Ausführungsformen alternativ möglich, die Streubereiche auch auf der von der Strahlformungseinrichtung wegweisenden Seite der Membranschicht anzuordnen, wie dies in Zusammenhang mit Figur 14 dargelegt wurde. Umgekehrt ist es auch möglich, bei der in Figur 14 dargestellten Ausführungsform die Streubereiche auf der der Strahlformungseinrichtung zuweisenden Seite der Membranschicht anzuordnen.

Ferner ist es, je nach konkret gewählter Ausführungsform, ebenfalls möglich, die Streubereiche auf der Membranschicht auf der gleichen Seite wie die Stege oder auf der jeweils entgegengesetzten Seite anzuordnen.

Bei den meisten der vorangehend beschriebenen Ausführungsformen weisen die Spitzen der dreieckigen Bereiche in der Maskenebene einen Abstand voneinander auf, der der lichten Weite zwischen benachbarten Stegen entspricht. Allerdings ist es ohne weiteres auch möglich, für den Abstand der Spitzen voneinander, d. h. für die Strahlbreite, einen geringeren Wert zu wählen.

## Patentansprüche

1. Projektionsvorrichtung zum Abbilden eines Musters einer Maske (31) auf ein mit einer strahlungsempfindlichen Schicht versehenes Substrat mittels eines Strahls projizierter geladener Teilchen,
wobei die Maske (31) aufweist:
- eine Membranschicht (37) aus einem ersten Material,
- das Muster bildende Streubereiche (39) aus einem die geladenen Teilchen stärker als die Membranschicht (37) streuenden zweiten Material,
- eine Mehrzahl von sich geradlinig erstreckenden, mit Abstand voneinander angeordneten und die Membranschicht (37) samt der Streubereiche (39) tragenden Stützstegen (33), und
- wenigstens einen Markierungsbereich,
und wobei die Projektionsvorrichtung umfaßt:
- eine Strahlformungseinrichtung (45) zum Erzeugen des Projektionsstrahls mit einem vorbestimmten Projektionsstrahlquerschnitt (43) in der Maskenebene,
- eine Positionier-Bewegungseinrichtung (57,55), um den Projektionsstrahlquerschnitt (43) in der Maskenebene relativ zu der Maske zu positionieren,
- ein Sensor (65) zur Abgabe eines Meßsignals (69), welches von einer Anzahl der geladenen Teilchen abhängt, die den Markierungsbereich (61) treffen,
- eine Steuerung (59) zur Ansteuerung der Positionier-Bewegungseinrichtung (57,55) in Abhängigkeit von dem Meßsignal (69),
**dadurch gekennzeichnet, daß**
die Positionier-Bewegungseinrichtung (57,55) dazu vorgesehen ist, den Projektionsstrahlquerschnitt (43) in der Maskenebene entlang einer vorbestimmten Bahn (49) parallel zu einer Erstreckungsrichtung der Stege (33) über die Maske(31) zu bewegen, und
die Steuerung (59) dazu ausgebildet ist, die Positionier-Bewegungseinrichtung (57,55) in Abhängigkeit von dem während der Bewegung des Projektionsstrahlquerschnitts (43) entlang der vorbestimmten Bahn (49) von dem Sensor abgegebenen Meßsignal anzusteuern.

2. Projektionsvorrichtung nach Anspruch 1, wobei die Positionier-Bewegungseinrichtung (57) auf das Meßsignal (69) anspricht, um Abweichungen Δy von der vorbestimmten Bahn (49) zu reduzieren.

3. Projektionsvorrichtung nach einem der Ansprüche 1 bis 2, wobei der Projektionsstrahlquerschnitt (43) in Richtung quer zu der Erstreckungsrichtung der Stege (33) eine Breite aufweist, die im wesentlichen der lichten Weite (d) zwischen benachbarten Stegen (33) entspricht.

4. Projektionsvorrichtung nach einem der Ansprüche 1 bis 3, wobei die Strahlformungseinrichtung ferner wenigsten einen zur Wechselwirkung mit dem Markierungsbereich (61) auf der Maske vorgesehenen Positionierungshilfsstrahl erzeugt, dessen Hilfsstrahlquerschnitt (75) in der Maskenebene bezüglich dem Projektionsstrahlquerschnitt (43) mit vorbestimmtem konstanten Abstand angeordnet ist.

5. Projektionsvorrichtung nach Anspruch 4, wobei der Hilfsstrahlquerschnitt (75) sich in eine Richtung quer zu einer Erstreckungsrichtung der Bahn (49) des Strahls kontinuierlich verjüngt.

6. Projektionsvorrichtung nach Anspruch 4 oder 5, wobei die Strahlformungseinrichtung zwei Positionierungshilfsstrahlen (75) erzeugt, deren Hilfsstrahlquerschnitte in der Maskenebene in Richtung quer zu der Erstreckungsrichtung der Stege (33b) mit einem lichten Abstand voneinander angeordnet sind, der größer ist als die lichte Weite zwischen benachbarten Stegen (33b).

7. Projektionsvorrichtung nach einem der Ansprüche 1 bis 6, wobei die Positionier-Bewegungseinrichtung (57) die Bahn des Projektionsstrahlquerschnitts (43) derart steuert, daß die Anzahl der den Markierungsbereich (61) treffenden geladenen Teilchen minimiert ist.

8. Projektionsvorrichtung nach einem der Ansprüche 1 bis 6, wobei die Positionier-Bewegungseinrichtung (57) die Bahn des Projektionsstrahlquerschnitts (43) derart steuert, daß die Anzahl der die Markierungsbereiche (61) treffenden geladenen Teilchen einem vorbestimmten Wert entspricht.

9. Projektionsvorrichtung nach Anspruch 1, wobei die Positionier-Bewegungseinrichtung (57) auf das Meßsignal anspricht, um die Bewegung des Projektionsstrahlquerschnitts (43) entlang der Bahn (49) zu beenden.

10. Maske für eine Projektionsvorrichtung zum Abbilden eines Musters der Maske auf ein mit einer strahlungsempfindlichen Schicht versehenes Substrat mittels eines Strahls projizierter geladener Teilchen, wobei die Maske (31) umfaßt:
- eine Membranschicht (37) aus einem ersten Material,
- das Muster bildende Streubereiche (39) aus einem die geladenen Teilchen stärker als die Membranschicht (37) streuenden zweiten Material,
- eine Mehrzahl von mit Abstand voneinander angeordneten und die Membranschicht (37) samt der Streubereiche (39) tragenden Stützstegen (33), und
- wenigstens einen durch ein Markierungsmaterial gebildeten Markierungsbereich (61), wobei sich das Markierungsmaterial hinsichtlich seiner Wechselwirkung mit den geladenen Teilchen von dem ersten und dem zweiten Material unterscheidet und diese Wechselwirkung mittels eines Sensors (65) nachweisbar ist,
**dadurch gekennzeichnet, daß** sich der Markierungsbereich (61) parallel zu einem diesem zugeordneten Steg (33) erstreckt.

11. Maske nach Anspruch 10, wobei das Markierungsmaterial eine andere Streuwirkung oder/und eine andere Reflexionswirkung oder/und eine andere Absorptionswirkung für die geladenen Teilchen aufweist als das erste und das zweite Material.

12. Maske nach Anspruch 10 oder 11, wobei die Wechselwirkung mittels eines Auger-Elektronendetektors oder/und eines Rückstreuelektronendetektors oder/und eines Röntgenstrahlungsdetektors (65) oder/und eines Fluoreszenzstrahlungsdetektors nachweisbar ist.

13. Maske nach einem der Ansprüche 10 bis 12, wobei der wenigstens eine Markierungsbereich (61) durch eine auf eine von der Membranschicht (37) abgewandten Stirnseite des Stegs (33) aufgebrachte Schicht aus dem Markierungsmaterial gebildet ist.

14. Maske nach einem der Ansprüche 10 bis 12, wobei der wenigstens eine Markierungsbereich (61a) durch eine zwischen der Membranschicht (37a) und dem Steg (33) angeordnete Markierungsschicht aus dem Markierungsmaterial gebildet ist.

15. Maske nach einem der Ansprüche 10 bis 12, wobei der wenigstens eine Markierungsbereich (61c) durch eine auf der dem Steg (33c) abgewandten Seite der Membranschicht (37c) angeordnete Markierungsschicht aus dem Markierungsmaterial gebildet ist.

16. Maske nach einem der Ansprüche 10 bis 15, wobei der wenigstens eine Markierungsbereich (61) durch den Steg (33) gebildet ist.

17. Maske nach einem der Ansprüche 10 bis 16, wobei der wenigstens eine Markierungsbereich (61), gesehen in Projektion parallel zu dem Teilchenstrahl(41), mit der projizierten Fläche des Stegs (33) zusammenfällt.

18. Maske nach einem der Ansprüche 10 bis 17, wobei der wenigstens eine Markierungsbereich (61), gesehen in Projektion parallel zu dem Teilchenstrahl (41), innerhalb der projizierten Fläche des Stegs (33) und mit einem vorbestimmten Abstand von deren Rändern angeordnet ist.

19. Maske nach einem der Ansprüche 10 bis 18, wobei der wenigstens eine Markierungsbereich (61g), gesehen in Projektion parallel zu dem Teilchenstrahl, außerhalb der projizierten Fläche des Stegs (33) angeordnet ist.

20. Maske nach Anspruch 19, wobei der wenigstens eine Markierungsbereich mit einem vorbestimmten Abstand von den Rändern des Stegs angeordnet ist.

21. Maske nach einem der Ansprüche 10 bis 20, wobei wenigstens ein Maskierungsbereich (81) vorgesehen ist, der, gesehen in Projektion parallel zu dem Teilchenstrahl, mit dem Markierungsbereich (61h) wenigstens teilweise überlappt und der aus einem geladene Teilchen stärker als die Membranschicht (37h) oder/und das Markierungsmaterial oder/und der Stützsteg (33h) streuenden Material gebildet ist.

22. Maske nach Anspruch 21, wobei das Material des Maskierungsbereichs (81) das Material des Streubereichs (39h) umfasst.

23. Maske nach einem der Ansprüche 10 bis 22, wobei das Markierungsmaterial zwei verschiedene Markierungmaterialien mit unterscheidbarer Wechselwirkung umfaßt, wobei benachbarten Stegen jeweils paarweise verschiedene Markierungsmaterialien zugeordnet sind.

24. Verfahren zur Belichtung einer strahlungsempfindlichen Schicht mittels durch eine Maske projizierter geladener Teilchen, umfassend:
Bereitstellen einer Maske (31), welche
- eine Membranschicht (37) aus einem ersten Material,
- das Muster bildende Streubereiche (39) aus einem die geladenen Teilchen stärker als die Membranschicht (37) streuenden zweiten Material,
- eine Mehrzahl von sich geradlinig erstreckenden, mit Abstand voneinander angeordneten und die Membranschicht (37) samt der Streubereiche (39) tragenden Stützstegen (33), und
- wenigstens einen Markierungsbereich aufweist,
Bereitstellen einer Projektionsvorrichtung, welche:
- eine Strahlformungseinrichtung (45) zum Erzeugen des Projektionsstrahls mit einem vorbestimmten Projektionsstrahlquerschnitt (43) in der Maskenebene,
- eine Positionier-Bewegungseinrichtung (57,55), um den Projektionestrahlquerschnitt (43) in der Maskenebene relativ zu der Maske zu positionieren,
- ein Sensor (65) zur Abgabe eines Meßsignals (69), welches von einer Anzahl der geladenen Teilchen abhängt, die den Markierungsbereich (61) treffen,
umfaßt, und wobei das Verfahren ferner ein Ansteuern der Positionier-Bewegungseinrichtung (57,55) in Abhängigkeit von dem Meßsignal (69) umfaßt,
**dadurch gekennzeichnet, daß**
der Projektionsstrahlquerschnitt (43) in der Maskenebene entlang einer vorbestimmten Bahn (49) parallel zu einer Erstreckungsrichtung der Stege (33) über die Maske(31) bewegt wird, und zwar in Abhängigkeit von dem während der Bewegung des Projektionsstrahlquerschnitts (43) entlang der vorbestimmten Bahn (49) von dem Sensor abgegebenen Meßsignal, oder/und das Bewegen entlang der vorbestimmten Bahn (49) wenigstens in Abhängigkeit von dem Meßsignal beendet wird.

25. Verfahren nach Anspruch 24, wobei der Projektionsstrahlquerschnitt (43) in der Maskenebene derart entlang der vorbestimmten Bahn (49) bewegt wird, daß die Anzahl der den Markierungsbereich treffenden geladenen Teilchen minimiert ist oder einem vorbestimmten Wert entspricht.

## Claims

1. A projection apparatus for imaging a pattern of a mask (31) onto a substrate comprising a radiation sensitive layer by means of a beam of projected charged particles,
wherein the mask (31) includes:
- a membrane layer (37) made of a first material, scattering regions (39) forming the pattern and made of a second material scattering the charged particles stronger than the membrane layer (37),
- a plurality of straightly extending supporting struts (33) spaced apart from one another and supporting the membrane layer (37) together with the scattering regions (39), and
- at least one mark region,
and wherein the projection apparatus includes:
- a beam shaping device (45) for producing the projection beam with a predetermined projection beam cross-section (43) in the mask plane,
- a positioning device (57, 55) for positioning the projection beam cross-section (43) in the mask plane relative to the mask,
- a sensor (65) for supplying a measuring signal (69) which is dependent on a number of charged particles impinging on the mark region (61), and
- a controller (59) for controlling the positioning device (57,55) dependent on the measuring signal (69),
**characterized in that**
the positioning device (57,55) is provided for moving the projection beam cross-section (43) in the mask plane along a predetermined path (49) over the mask (31) parallel to a direction into which the struts (33) extend, and
the controller (59) is provided for controlling the positioning device (57, 55) dependent on the measuring signal delivered by the sensor during the movement of the projection beam cross-section (43) along the predetermined path (49).

2. The projection apparatus according to claim 1, wherein the positioning device (57) is responsive to the measuring signal (69) in order to reduce deviations (Δy) from the predetermined path (49).

3. The projection apparatus according to one of claims 1 to 2, wherein the projection beam cross-section (43) has a width transverse to the direction into which the struts (33) extend which corresponds substantially to the clear width (d) between adjacent struts (33).

4. The projection apparatus according to one of claims 1 to 3, wherein the beam shaping device furthermore produces at least one auxiliary positioning beam to interact with the mark region (61) provided on the mask, wherein a cross-section (75) of the auxiliary beam is positioned in the mask plane at a predetermined constant distance relative to the projection beam cross-section (43).

5. The projection apparatus according to claim 4, wherein the auxiliary beam cross-section (75) continuously tapers into a direction transverse to a direction into which the path (49) of the beam extends.

6. The projection apparatus according to claim 4 or 5, wherein the beam shaping device produces two auxiliary positioning beams (75), whose auxiliary beam cross-sections are spaced apart from one another in the mask plane transverse to the direction into which the struts (33b) extend by a clear distance which is larger than the clear width between adjacent struts (33b).

7. The projection apparatus according to one of claims 1 to 6, wherein the positioning device (57) controls the path of the projection beam cross-section (43) such that the number of charged particles impinging on the mark region (61) is minimized.

8. The projection apparatus according to one of claims 1 to 6, wherein the positioning device (57) controls the path of the projection beam cross-section (43) such that the number of charged particles impinging on the mark regions (61) corresponds to a predetermined value.

9. The projection apparatus according to claim 1, wherein the positioning device (57) is responsive to the measuring signal to stop the movement of the projection beam cross-section (43) along the path (49).

10. A mask for a projection apparatus for imaging a pattern of the mask onto a substrate comprising a radiation sensitive layer by means of a beam of projected charged particles, the mask (31) comprising:
- a membrane layer (37) made of a first material,
- scattering regions (39) forming the pattern and made of a second material scattering the charged particles stronger than the membrane layer (37) and
- a plurality of supporting struts (33) spaced apart from one another and supporting the membrane layer (37) together with the scattering regions (39), and
- at least one mark region (61) formed of a mark material, wherein the mark material differs from the first and second materials as regards its interaction with the charged particles, said interaction being detectable by means of a sensor (65),
**characterized in that**
the mark region (61) extends parallel to a strut (33) associated therewith.

11. The mask according to claim 10, wherein the mark material exhibits a different scattering effect or/and a different reflection effect or/and a different absorption effect for the charged particles than the first and second materials.

12. The mask according to claim 10 or 11, wherein the interaction is detectable by means of an Auger electron detector or/and a backscattering electron detector or/and an X-ray detector (65) or/and a fluorescence radiation detector.

13. The mask according to one of claims 10 to 12, wherein at least one mark region (61) is formed by a layer of the mark material applied on an end face of the strut (33) facing away from the membrane layer (37).

14. The mask according to one of claims 10 to 12, wherein at least one mark region (61a) is formed by a mark layer of the mark material positioned between the membrane layer (37a) and the strut (33).

15. The mask according to one of claims 10 to 12, wherein at least one mark region (61c) is formed by a mark layer of the mark material positioned on the side of the membrane layer (37c) facing away from the strut (33c).

16. The mask according to claim one of claims 10 to 15, wherein at least one mark region (61) is formed by the strut (33).

17. The mask according to one of claims 10 to 16, wherein at least one mark region (61), viewed in projection parallel to the particle beam (41), coincides with the projected area of the strut (33).

18. The mask according to one of claims 10 to 17, wherein at least one mark region (61), viewed in projection parallel to the particle beam (41), is positioned within the projected area of the strut (33) and at a predetermined distance from the edges thereof.

19. The mask according to one of claims 10 to 18, wherein at least one mark region (61g), viewed in projection parallel to the particle beam, is positioned outside of the projected area of the strut (33).

20. The mask according to claim 19, wherein at least one mark region is positioned at a predetermined distance from the edges of the strut.

21. The mask according to one of claims 10 to 20, wherein at least one masking region (81) is provided which, viewed in projection parallel to the particle beam, overlaps with the mark region (61h) at least partially and is formed of a material which scatters charged particles stronger than the membrane layer (37h) or/and the mark material or/and the supporting strut (33h).

22. The mask according to claim 21, wherein the material of the masking region (81) comprises the material of the scattering region (39h).

23. The mask according to one of claims 10 to 22, wherein the mark material comprises two different mark materials with distinguishable interaction, wherein different mark materials are in each case assigned to adjacent struts.

24. A method for exposing a radiation sensitive layer by means of charged particles projected through a mask, the method comprising:
providing a mask (31) which includes:
- a membrane layer (37) made of a first material,
- scattering regions (39) forming the pattern and made of a second material scattering the charged particles stronger than the membrane layer (37),
- a plurality of straightly extending supporting struts (33) spaced apart from one another and supporting the membrane layer (37) together with the scattering regions (39), and
- at least one mark region,
providing a projection apparatus which includes:
- a beam shaping device (45) for producing the projection beam with a predetermined projection beam cross-section (43) in the mask plane,
- a positioning device (57, 55) for positioning the projection beam cross-section (43) in the mask plane relative to the mask,
- a sensor (65) for supplying a measuring signal (69) which is dependent on a number of charged particles impinging on the mark region (61), and
wherein the method further comprises controlling the positioning device (57,55) dependent on the measuring signal (69),
**characterized in that**
the projection beam cross-section (43) is moved in the mask plane along a predetermined path (49) over the mask (31) parallel to a direction into which the struts (33) extend, and that dependent on the measuring signal delivered by the sensor during the movement of the projection beam cross-section (43) along the predetermined path (49), or/and the movement along the predetermined path (49) is terminated at least dependent on the measuring signal.

25. A method according to claim 24, wherein the projection beam cross-section (43) is moved in the mask plane along the predetermined path (49) such that the number of the charged particles impinging onto the mark region is minimized or corresponds to a predetermined value.

## Revendications

1. Dispositif de projection pour reproduire un motif d'un masque (31) sur un substrat muni d'une couche sensible aux radiations au moyen d'un rayon de particules chargées projetées,
dans lequel le masque (31) présente :
- une couche à membrane (37) constituée d'un premier matériau ;
- des zones de diffusion (39) formant le motif et constituées d'un second matériau qui diffuse les particules chargées plus fortement que la couche à membrane (37) ;
- une pluralité de barrettes de soutien (33) s'étendant en ligne droite, agencées à distance les unes des autres et portant la couche à membrane (37) avec les zones de diffusion (39) ; et
- au moins une zone de marquage,
et dans lequel le dispositif de projection comporte :
- un dispositif générateur de rayon (45) pour générer le rayon de projection avec une section transversale de rayon de projection prédéterminée (43) dans le plan de masque ;
- un dispositif de positionnement et de déplacement (57, 55) pour positionner la section transversale de rayon de projection (43) dans le plan de masque relativement par rapport au masque ;
- un capteur (65) pour émettre un signal de mesure (69) qui dépend d'un nombre des particules chargées qui atteignent la zone de marquage (61) ; et
- une commande (59) pour piloter le dispositif de positionnement et de déplacement (57, 55) en fonction du signal de mesure (69),
**caractérisé en ce que** :
- le dispositif de positionnement et de déplacement (57, 55) est prévu pour déplacer la section transversale de rayon de projection (43) dans le plan de masque le long d'une trajectoire prédéterminée (49) parallèlement à une direction d'extension des barrettes (33) sur le masque (31) ; et
- la commande (59) est réalisée pour piloter le dispositif de positionnement et de déplacement (57, 55) en fonction du signal de mesure émis par le capteur pendant le déplacement de la section transversale de rayon de projection (43) le long de la trajectoire prédéterminée (49).

2. Dispositif de projection selon la revendication 1, dans lequel le dispositif de positionnement et de déplacement (57) réagit au signal de mesure (69) pour réduire des écarts (Δy) envers la trajectoire prédéterminée (49).

3. Dispositif de projection selon l'une des revendications 1 à 2, dans lequel la section transversale de rayon de projection (43) présente dans la direction perpendiculaire à la direction d'extension des barrettes (33) une largeur qui correspond sensiblement à la largeur intérieure (d) entre des barrettes adjacentes (33).

4. Dispositif de projection selon l'une des revendications 1 à 3, dans lequel le dispositif générateur de rayon génère en outre au moins un rayon auxiliaire de positionnement prévu sur le masque pour l'effet alternant avec la zone de marquage (61), dont la section transversale de rayon auxiliaire (75) est agencée dans le plan de masque à une distance constante prédéterminée par rapport à la section transversale de rayon de projection (43).

5. Dispositif de projection selon la revendication 4, dans lequel la section transversale de rayon auxiliaire (75) s'amincit continuellement dans une direction perpendiculaire à une direction d'extension de la trajectoire (49) du rayon.

6. Dispositif de projection selon la revendication 4 ou 5, dans lequel le dispositif générateur de rayon génère deux rayons auxiliaires de positionnement (75) dont les sections transversales de rayon auxiliaire sont agencées dans le plan de masque, en direction perpendiculaire à la direction d'extension des barrettes (33b), à une distance intérieure l'une de l'autre, laquelle est plus grande que la largeur intérieure entre deux barrettes adjacentes (33b).

7. Dispositif de projection selon l'une des revendications 1 à 6, dans lequel le dispositif de positionnement et de déplacement (57) commande la trajectoire de la section transversale de rayon de projection (43) de manière à minimiser le nombre de particules chargées qui atteignent la zone de marquage (61).

8. Dispositif de projection selon l'une des revendications 1 à 6, dans lequel le dispositif de positionnement et de déplacement (57) commande la trajectoire de la section transversale de rayon de projection (43) de sorte que le nombre de particules chargées qui atteignent les zones de marquage (61) correspond à une valeur prédéterminée.

9. Dispositif de projection selon la revendication 1, dans lequel le dispositif de positionnement et de déplacement (57) réagit au signal de mesure pour terminer le déplacement de la section transversale de rayon de projection (43) le long de la trajectoire (49).

10. Masque pour un dispositif de projection pour reproduire un motif du masque sur un substrat muni d'une couche sensible aux radiations au moyen d'un rayon de particules chargées projetées, dans lequel le masque (31) comporte :
- une couche à membrane (37) constituée d'un premier matériau ;
- des zones de diffusion (39) formant le motif et constituées d'un second matériau qui diffuse les particules chargées plus fortement que la couche à membrane (37) ;
- une pluralité de barrettes de soutien (33) agencées à distance les unes des autres et portant la couche à membrane (37) avec les zones de diffusion (39) ; et
- au moins une zone de marquage (61) formée par un matériau de marquage, dans laquelle le matériau de marquage se différencie du premier et du second matériau quant à son effet alternant avec les particules chargées et dans laquelle cet effet alternant peut être prouvé au moyen d'un capteur (65),
**caractérisé en ce que** la zone de marquage (61) s'étend parallèlement à une barrette (33) attribuée à celle-ci.

11. Masque selon la revendication 10, dans lequel le matériau de marquage présente un autre effet de diffusion ou/et un autre effet de réflexion ou/et un autre effet d'absorption pour les particules chargées que le premier et le second matériau.

12. Masque selon la revendication 10 ou 11, dans lequel l'effet alternant peut être prouvé au moyen d'un détecteur d'électrons Auger et/ou d'un détecteur d'électrons de rétrodiffusion et/ou d'un détecteur de radiations X (65) et/ou d'un détecteur de radiations fluorescentes.

13. Masque selon l'une des revendications 10 à 12, dans lequel au moins une zone de marquage (61) est formée par une couche constituée du matériau de marquage et apposée sur une face frontale de la barrette (33), laquelle est détournée de la couche à membrane (37).

14. Masque selon l'une des revendications 10 à 12, dans lequel au moins une zone de marquage (61a) est formée par une couche de marquage constituée du matériau de marquage, agencée entre la couche à membrane (37a) et la barrette (33).

15. Masque selon l'une des revendications 10 à 12, dans lequel au moins une zone de marquage (61c) est formée par une couche de marquage constituée du matériau de marquage, agencée sur une face de la couche à membrane (37c), laquelle est détournée de la barrette (33c).

16. Masque selon l'une des revendications 10 à 15, dans lequel au moins une zone de marquage (61) est formée par la barrette (33).

17. Masque selon l'une des revendications 10 à 16, dans lequel au moins une zone de marquage (61) coïncide avec la surface projetée de la barrette (33), en regardant dans la projection parallèlement au rayon de particules (41).

18. Masque selon l'une des revendications 10 à 17, dans lequel au moins une zone de marquage (61) est agencée à l'intérieur de la surface projetée de la barrette (33) et à une distance prédéterminées des bords de celle-ci, en regardant dans la projection parallèlement au rayon de particules (41).

19. Masque selon l'une des revendications 10 à 18, dans lequel au moins une zone de marquage (61g) est agencée à l'extérieur de la surface projetée de la barrette (33), en regardant dans la projection parallèlement au rayon de particules.

20. Masque selon la revendication 19, dans lequel au moins une zone de marquage est agencée à une distance prédéterminée des bords de la barrette.

21. Masque selon l'une des revendications 10 à 20, dans lequel on a prévu au moins une zone de marquage (81) qui, en regardant dans la projection parallèlement au rayon de particules, chevauche au moins partiellement la zone de marquage (61h) et qui est formée à partir d'un matériau qui diffuse des particules chargées plus fortement que la couche à membrane (37h) et/ou que le matériau de marquage et/ou que la barrette de soutien (33h).

22. Masque selon la revendication 21, dans lequel le matériau de la zone de marquage (81) comporte le matériau de la zone de diffusion (39h).

23. Masque selon l'une des revendications 10 à 22, dans lequel le matériau de marquage comprend deux différents matériaux de marquage avec un effet alternant pouvant être différencié et dans lequel des barrettes adjacentes sont attribuées respectivement par paires à des matériaux de marquage différents.

24. Procédé pour exposer une couche sensible aux radiations au moyen de particules chargées projetées par un masque, comprenant :
* la mise à disposition d'un masque (31) qui présente :
- une couche à membrane (37) constituée d'un premier matériau ;
- des zones de diffusion (39) formant le motif et constituées d'un second matériau qui diffuse les particules chargées plus fortement que la couche à membrane (37) ;
- une pluralité de barrettes de soutien (33) s'étendant en ligne droite, agencées à distance les unes des autres et portant la couche à membrane (37) avec les zones de diffusion (39) ; et
- au moins une zone de marquage,
* la mise à disposition d'un dispositif de projection qui comporte :
- un dispositif générateur de rayon (45) pour générer le rayon de projection avec une section transversale de rayon de projection prédéterminée (43) dans le plan de masque ;
- un dispositif de positionnement et de déplacement (57, 55) pour positionner la section transversale de rayon de projection (43) dans le plan de masque relativement par rapport au masque ;
- un capteur (65) pour émettre un signal de mesure (69) qui dépend d'un nombre des particules chargées qui atteignent la zone de marquage (61),
et dans lequel le procédé comporte en outre un pilotage du dispositif de positionnement et de déplacement (57, 55) en fonction du signal de mesure (69),
**caractérisé en ce que** la section transversale de rayon de projection (43) est déplacée dans le plan de masque le long d'une trajectoire prédéterminée (49) parallèlement à une direction d'extension des barrettes (33) sur le masque (31) et cela en fonction du signal de mesure émis par le capteur pendant le déplacement de la section transversale de rayon de projection (43) le long de la trajectoire prédéterminée (49), et/ou **en ce que** le déplacement le long de la trajectoire prédéterminée (49) est terminé au moins en fonction du signal de mesure.

25. Procédé selon la revendication 24, dans lequel la section transversale de rayon de projection (43) est déplacée dans le plan de masque le long de la trajectoire prédéterminée (49) de sorte que le nombre de particules chargées qui atteignent la zone de marquage est minimisé ou correspond à une valeur prédéterminée.
